(19) **Europäisches Patentamt European Patent Office Office européen des brevets**

(11) **EP 4 579 757 A1**

(12) **EUROPEAN PATENT APPLICATION**

(43) Date of publication:
**02.07.2025  Bulletin 2025/27**

(21) Application number: **23386143.4**

(22) Date of filing: **29.12.2023**

(51) International Patent Classification (IPC):
*H01L 29/16* (2006.01)    *H01L 29/32* (2006.01)
*H01L 29/76* (2006.01)    *B82Y 10/00* (2011.01)
*H01L 29/40* (2006.01)

(52) Cooperative Patent Classification (CPC):
**H10D 48/385; G06N 10/00; H10D 30/402;**
**H10D 48/3835; H10D 62/53; H10D 62/8303;**
**H10D 62/8325;** B82Y 10/00; **H10D 64/01**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Quantum Brilliance GmbH**
**70565 Stuttgart (DE)**

(72) Inventors:
• **VÖRÖS, Zoltán**
**70565 Stuttgart (DE)**

• **BOUGAS, Lykourgos**
**70565 Stuttgart (DE)**
• **MAJIDI, Danial**
**70565 Stuttgart (DE)**
• **WACHTER, Georg**
**70565 Stuttgart (DE)**
• **EISENACH, Erik**
**70565 Stuttgart (DE)**

(74) Representative: **Sonnenberg Harrison**
**Partnerschaft mbB**
**Herzogspitalstraße 10a**
**80331 München (DE)**

(54) **DEVICE AND METHOD FOR ELECTRICAL READOUT OF POINT DEFECT SPINS**

(57)  A quantum information processing device is disclosed. The quantum information processing device comprises a semiconductor device and a single-electron electrometer electrically connected to the semiconductor device. The semiconductor device comprises a plurality of point defects having a plurality of quantum states associated with at least one electron. First transitions are effectible between first ones of the plurality of quantum states by means of electromagnetic signals interacting with the at least one electron. Second transitions occur between second ones of the plurality of states. At least some of the plurality of point defects are arranged in the semiconductor device at distances below 20 nm. The single-electron electrometer is configured to be operated at frequencies of 1 MHz or more.

FIG. 4

EP 4 579 757 A1

## Description

### Technical field

The present disclosure belongs to the fields of the quantum information processing and quantum computing.

The present disclosure relates to a device and a method for electrical readout of electronic spins associated with point defects in a semiconductor device.

### Background of the disclosure

The quantum physics of diamond-based nitrogen-vacancy centers (NV-centers) has led to diamond devices enabling sensing at room temperature by means of electron spins located at the NV-centers. For example, magnetic fields can be measured at room temperature with high accuracy and high resolution by means of the diamond devices.

Developing an integrated quantum chip capable of quantum information processing for executing digital quantum computing operations based on point defects in a semiconductor material, like the NV centers in diamond, requires a scalable physical hardware platform, including a scalable quantum system with reliable qubits. Reliable qubits require the ability to perform qubit-specific quantum operations, e.g., initialization, control, and readout, with a high fidelity and at fast timescales. The integrated chip further requires control and readout structures.

### Summary of the disclosure

The present disclosure relates to a device and a method for electric readout of spin states of electrons of NV-centers.

A quantum information processing device is disclosed. The quantum information processing device comprises a semiconductor device and a single-electron electrometer electrically connected to the semiconductor device. The semiconductor device comprises a plurality of point defects having a plurality of quantum states associated with at least one electron. First transitions are effectible between first ones of the plurality of quantum states by means of electromagnetic signals interacting with the at least one electron. Second transitions occur between second ones of the plurality of states. At least some of the plurality of point defects are arranged in the semiconductor device at distances below 20 nm. The single-electron electrometer is configured to be operated at frequencies of 1 MHz or more.

The single-electron electrometer may comprise an amplifier configured to be operated at frequencies of 1 MHz or more.

The amplifier comprises at least one of a single-electron transistor or a bipolar transistor.

The quantum information processing device may further comprise an electromagnetic source for generating the electromagnetic signals.

The electromagnetic source may be an optical source, and the electromagnetic signals may be optical signals.

The semiconductor device may further comprise impurities.

The impurities may comprise electron donors and/or electron acceptors.

The single-electron electrometer may be electrically connected to the semiconductor device by means of electrodes.

A method of manufacturing a quantum information processing device is disclosed. The method comprises the steps of providing a semiconductor device. The method further comprises a step of fabricating a plurality of point defects, having a plurality of quantum states associated with at least one electron. First transitions are effectible between first ones of the plurality of quantum states by means of electromagnetic signals interacting with the at least one electron. Second transitions occur between second ones of the plurality of states. At least some of the plurality of point defects are arranged in the semiconductor device at distances below 20 nm. The method further comprises the step of arranging a plurality of electrodes on the semiconductor device. The method further comprises the step of electrically connecting the semiconductor device with a single-electron electrometer via the plurality of electrodes, wherein the single-electron electrometer is configured to be operated at frequencies of 1MHz or more.

The method may further comprise providing an electromagnetic source for generating electromagnetic signals configured to interact with the plurality of point defects.

The providing of an electromagnetic source may comprise providing an optical source.

The method may further comprise introducing impurities to the semiconductor device.

The method may further comprise arranging the semiconductor device on a chip.

The method may further comprise arranging the electromagnetic source on the chip.

## Brief description of the drawings

FIG. 1 is a schematic of quantum states of an NV-center in a semiconductor device made of diamond.

FIG. 2 is a schematic of an arrangement of NV-centers in diamond.

FIGS. 3A-3F shows simulation results for a photocurrent and a photoluminescence of an NV-center resulting from excitation by means of an electromagnetic driving signal.

FIG. 4 shows a quantum information processing device.

FIG. 5 shows a method of manufacturing a quantum information processing device.

## Detailed description

The present disclosure relates to a quantum information processing device comprising a semiconductor device 15, the semiconductor device 15 comprising a plurality of point defects 20 arranged in the semiconductor device 15. The quantum information processing device enables electrical readout of an electronic spin state associated with a selected one of the plurality of point defects 20.

The semiconductor device 15 is made from a semiconducting material. Examples of the semiconducting material are diamond or silicon carbide. The semiconductor device 15 may comprise dopants 23, such as electron donors and/or electron acceptors. The dopants 23 enable altering an electrical conductivity of the semiconductor device 15.

A point defect of the plurality of point defects 20 is a crystalline defect at a lattice point of a crystalline lattice. The point defect is known to have atom-like properties. An example of the atom-like properties are electronic states of the point defect, defined, for instance, by an orbital, an angular momentum, and/or an electronic spin. Another example of the atom-like properties are interactions between the orbital, the electronic spin, nuclear spins, phonons, and external fields.

Furthermore, the point defect may have one or more electric charge states corresponding to different electrical charge values of the point defect.

An example of the point defect is an NV-center (nitrogen-vacancy center) in diamond. The NV-center comprises a vacancy in the diamond lattice and a nitrogen atom at one of the nearest-neighbour lattice points. A further example of the point defect is a silicon vacancy (SiV) in diamond.

Other examples of the point defect are a silicon vacancy (SiV) or a carbon vacancy in silicon carbide.

The NV-center has a neutral electric charge state $NV^0$, in which the electric charge value of the NV-center is 0 (neutrally charged NV-center). The NV-center furthermore has a negative electric charge state $NV^-$, in which the electric charge value of the NV-center is $-1e = -1.6 \times 10^{-19}$ C (negatively charged NV-center).

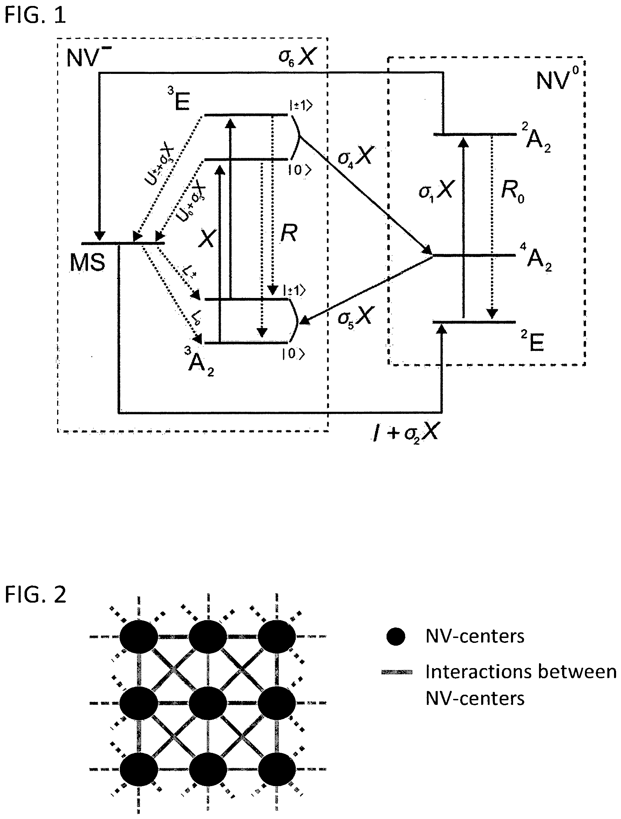

FIG. 1 shows a system relating to the NV-center in diamond. The system comprises a plurality of quantum states as well as a plurality of transitions among the plurality of quantum states. The plurality of transitions enable a control of the system by means of one or more electromagnetic driving signals to alter occupancies associated with the plurality of quantum states. The occupancies may be altered such that the NV-center is initialised to an initialisation state, e.g., to the state $^3A_2$ with electronic spin state $|0>$.

When the NV-center is initialised to the initialisation state having a defined electron spin state, the NV-center is also said to be polarised. One way of achieving the initialisation state (or polarised state) is to alter the occupancies of the plurality of quantum states by driving the NV-center by means of exposure to the electromagnetic driving signals, e.g., to optical radiation. In one aspect of the disclosure, by initialising the NV-center the nuclear spins may be initialised. The nuclear spins may be initialised based on interactions of the electronic spins and the nuclear spins, such as hyperfine interactions.

The transitions further enable a readout of at least one current one of the plurality of quantum states (referred to as the current state). The current state may depend on one or more of the nuclear spins in a vicinity of the NV-center. The readout of the nuclear-spin dependent current state enables readout of the one or more of the nuclear spins. Such readout enables the quantum information processing device to be used for a quantum computer. In one aspect, the electronic states may be used for initialisation or readout of the current state, and the nuclear spin states may be used as qubits for the quantum computer (see also below).

FIG. 1 shows the plurality of quantum states of the NV-center in diamond. The plurality of quantum states are associated with electronic states and with the charge states $NV^0$ and $NV^-$ of the NV-center in diamond. The charge states $NV^0$ and $NV^-$ are indicated by the dashed rectangles in FIG. 1. The electronic states are indicated in FIG. 1 by bold horizontal lines.

For the neutral charge state $NV^0$, the electronic states include the doublet states $^2A_2$ and $^2E$ as well as the metastable state $^4A_2$.

For the negative charge state $NV^-$, the electronic states include the excited triplet state $^3E$, the triplet ground state $^3A_2$, and one or more metastable singlet states MS.

FIG. 1 furthermore shows the plurality of transitions among the plurality of quantum states of the NV-center. The arrows shown in FIG. 1 represent ones of the plurality of transitions among the electronic states and/or among transitions the charge states. The plurality of transitions are each associated with an initial state and a final state from the plurality of quantum states. The plurality of transitions are each associated with an energy difference $\Delta E_{trans}$ between the initial state and the final state. When one of the plurality of transitions occurs, an electron occupying the corresponding initial state transitions, or is transferred, to the corresponding final state. The plurality of transitions are each associated with a transition rate, e.g., one of the transition rates $X, R, R_0$, shown FIG. 1. Some of the transitions are associated with a photon absorption cross-section $\sigma_i$, the multiplication of which by a power of an electromagnetic driving signal (see below), e.g., $X$ or $I$ in FIG. 1, results in the corresponding transition rate. The transition rates may be in a range of approximately 1 to 100 MHz (see, e.g., Gulka et al. (2021) or Razinkovas et al. (2021)). The cross-sections may be in a range of approximately 1 to 100 MHz/mW (see, e.g., Gulka et al. (2021) or Razinkovas et al. (2021)). The transition rates and the cross-sections may be determined experimentally and/or by parameter estimation based on fitting a model (see below).

The transitions rates in FIG. 1 that are not associated with a change of the charge state include the optical excitation rate $X$; the radiative decay rates $R$ and $R_0$; the upper inter-system-crossing (ISC) rates $U_\pm + \sigma_3 X$ and $U_0 + \sigma_3 X$, that include spin-dependent terms $U_\pm$, $U_0$ and a wavelength-dependent and charge dynamics-related scaling term $\sigma_3 X$; the lower inter-system-crossing spin-dependent rates $L_\pm$ and $L_0$; and the optical excitation rate $\sigma_1 X$ of the transition of the neutrally charged NV center.

The transitions rates in FIG. 1 that are associated with a change of the charge state include the ionization rate $\sigma_4 X$ from the excited triplet state $^3E$ of the $NV^-$ to the metastable $^4A_2$ state of the $NV^0$, the recombination rate $\sigma_5 X$ from the metastable $^4A_2$ electronic state of the $NV^0$ to the triplet ground state of the $NV^-$, the combined ionization rate $I + \sigma_2 X$ from both singlet states of the $NV^-$ to the $^2E$ state of the $NV^0$, and the recombination rate $\sigma_6 X$ from the $^2A_2$ electronic state of the $NV^0$ to the lower singlet state of the $NV^-$.

Upward-pointing continuous arrows indicate energy-increasing transitions to an electronic state of higher energy. The energy-increasing transitions occur upon an interaction between an electron, occupying the corresponding initial state, and an electromagnetic driving signal generated by means of an electromagnetic source or illumination laser 50, e.g., during pumping. A photon of the electromagnetic driving signal interacts with an electron, occupying the corresponding initial state. The interaction of the photon with the electron results in the energy-increasing transition. The illumination laser 50 may generate one of the electromagnetic driving signals having a wavelength in the optical range.

When the electromagnetic driving signal has a wavelength $\lambda_{exc}$ in an excitation wavelength range corresponding to the energy difference between the initial state and the final state of the corresponding energy-increasing transition, the interaction between the photon of the electromagnetic signal and an electron occupying the initial state may be more likely to result in this transition. The photon of the electromagnetic signal, which has a wavelength in the excitation wavelength range, has an energy equal to, or in a range about, the energy difference $\Delta E_{trans}$ of the corresponding transition (i.e., $E_{photon} = h\,c/\lambda_{exc} \approx \Delta E_{trans}$, where $h$ is Planck's constant and c is the speed of light). In this way, each energy-increasing transitions is associated with a corresponding excitation wavelength range, in which a probability of this energy-increasing transition occurring is increased.

Downward-pointing dotted arrows indicate energy-decreasing transitions to an electronic state of lower energy. The energy-decreasing transitions occur spontaneously. Furthermore, the energy-decreasing transitions may be stimulated, e.g., by electromagnetic signal.

When one of the energy-decreasing transitions occurs, a photon is emitted by an electron transitioning from the corresponding initial state to the corresponding final state. This emission of a photon is referred to as photoluminescence. The photoluminescence photon has a wavelength substantially equal to the energy difference $\Delta E_{trans}$ of the corresponding energy-decreasing transition. The photoluminescence enables readout of the current state of the NV-center.

Upon exposing the NV-center to the electromagnetic driving signal, occupancies associated with the plurality of quantum states (i.e., probabilities, associated with the plurality of quantum states, of an electron occupying the corresponding quantum state) change. Based on a quantum mechanical model, a time evolution of the occupancies associated with the plurality of quantum states can be calculated or simulated (see below).

The calculated or simulated time evolution of the occupancies associated with the plurality of quantum states results in sequences of transitions of one or more electrons among the plurality of quantum states. The sequences of transitions lead to experimentally detectable signals.

When the sequence of transitions results in a change of the charge state of the NV-center, i.e., from the negative charge state $NV^-$ to the neutral charge state $NV^0$ or from the neutral charge state $NV^0$ to the negative charge state $NV^-$, an electron is removed from the systems or added to the system, respectively.

When an electron is removed from the negatively charged NV-center $NV^-$, the electron may be transferred to a conduction band of the semiconductor device 15. The removal of the electron from the NV-center occurs by a single-photon or two-photon ionization process. In the single-photon ionization process, an electron is photoelectrically transferred from the state $^3A_2$ to the conduction band. An experimentally determined photon energy for the single-photon process is approximately 2.6 to 2.7 eV. In the two-photon ionization process, in which excitation of an electron to an excited state, e.g., to the state $^3E$, and subsequent photoelectrical transferal of the excited electron from the excited state, e.g., from the state $^3E$, to the conduction band occur. An efficiency of the two-photon ionization may be enhanced by increasing the power of the electromagnetic driving signal.

In the conduction band, the electron, photoelectrically transferred to the conduction band, may be shuttled or moved in the conduction band by applying an electric field (or voltage). For example, the photoelectrically transferred electron may be moved by an electric field to an electrometer. Such shuttling or movement of the photoelectrically transferred electron to the electrometer enables detecting the photoelectrically transferred electron at the electrometer. Detecting a plurality of the photoelectrically transferred electron at the electrometer for a detection period enables measuring an electron current (current of transferred electrons) at the electrometer for the detection period. The electron current contributes to a measured current measured by the electrometer. When the measured current is driven by the two-photon ionization process, the measured current is referred to as photocurrent.

When an electron is added to the neutrally charged NV-center $NV^0$, the electron may be transferred from a valence band of the semiconductor device 15 to the NV-center. One possible mechanism for the adding of an electron to the NV-center is electron capture ionization. When an electron from the valence band is added to the NV-center, a hole is generated in the valence band. The generated hole may contribute to the photocurrent measured at the electrometer. More generally, a plurality of the holes may generate a hole current. The hole current generated during the detection period may contribute to the measured current measured by the electrometer. For example, the hole current may contribute to the photocurrent. For example, the electron current and the hole current may each add to the photocurrent.

As schematically shown in FIG. 2, the plurality of point defects 20 is arranged in the form of an array that is two-dimensional or three-dimensional. The array may be arranged at a distance to a surface of a semiconductor device 15 (described below). The distance enables electrical and electromagnetic control of a single one of the plurality of point defects 20. The array may be arranged close to the surface of the semiconductor device 15, on which electrodes are arranged. The distance of the array from the surface may be chosen so as to increase the probability of detecting an electron transferred from the plurality of point defects 20 to a conduction band of the semiconductor device 15. The arrangement the plurality of NV-centers in the array means that any one of the plurality of NV-centers has at least one neighbouring one of the plurality of NV-centers. In one aspect of the disclosure, defect distances between ones of the plurality of point defects 20 and the corresponding at least one neighbouring one (nearest-neighbour distance of the array) is less than 20 nm. In a further aspect, the defect distances are less than or equal to 10 nm. In yet a further aspect, the defect distances are less than or equal to 5 nm.

The plurality of point defects 20 arranged in the array shown in FIG. 2 are coupled by a spin-spin interaction between the electronic spins at the plurality of point defects 20. The spin-spin interaction (magnetic dipole-dipole interaction) follows the inverse 3rd power law, i.e., $1/r^3$, where r is the defect distance between the interacting electronic spins. The spin-spin interaction decreases rapidly when the defect distance between interacting ones of the plurality of point defects 20 increases. The defect distances being «20nm enables the coupling strengths (in terms of frequency » kHz) between the plurality of point defects 20 that ensure high-fidelity high-speed quantum operations of initialization, control, and readout.

During manufacturing of the semiconductor device 15, the fabrication of the plurality of point defects 20 is controllable such that the defect distances lie in a predetermined range. In one example, this predetermined range of the defect distances between the plurality of point defects 20 comprises values smaller than or equal to 20 nm. In another example, this range comprises values smaller than or equal to 10 nm. In a further example, this range comprises values of about 5 nm, such as values larger than or equal to 3 nm and smaller than or equal to 7 nm, or values larger than or equal to 4 nm and smaller than or equal to 6 nm.

Controlling the defect distance of the plurality of point defects 20 during the fabricating of the plurality of point defects 20 enables controlling the interactions of the electronic spins at the plurality of point defects 20, i.e., interactions of spin magnetic moments of the electrons at the plurality of point defects 20. This interaction, scaling with $1/r^3$ (see above), enables entanglement of the interacting electronic spins.

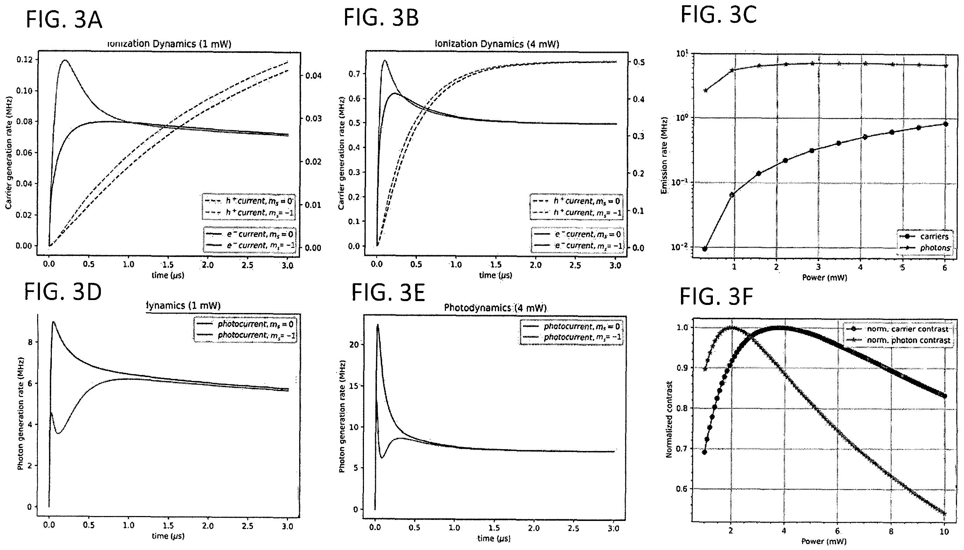

FIG. 3A-3F shows results of simulating the NV-center based on the plurality of quantum states and plurality of transitions, shown in FIG. 1, using a quantum mechanical model. One example of the quantum mechanical model is the Lindblad master equation, which describes the time evolution of a density matrix p, involving a Hamiltonian H and Lindblad jump operators $L_k$. The Lindblad jump operators $L_k$ describe the transitions using the transitions rates between the electronic states and/or the charge states (described above with reference to FIG. 1).

The Hamiltonian $H$ of the Lindblad master equation includes a spin Hamiltonian. The spin Hamiltonian includes the electronic Zeeman energy as well as electron spin-spin interactions (magnetic dipole-diploe interactions) in the triplet ground $^3A_2$ and the triplet excited state $^3E$ of the negative charge state $NV^-$.

The quantum mechanical model describes the time evolution of the system shown in FIG. 1. Based on the time evolution of the system, time evolutions of the occupancies associated with the plurality of quantum states can be calculated. Based on the time evolutions of the occupancies, the photocurrent and/or the photoluminescence associated with the NV-center can be calculated.

In another aspect, nuclear spins, e.g., in the case of the NV-center, the nuclear spin of the nitrogen atom of the NV-center, and/or one or more of the nuclear spins of the carbon atoms and/or nitrogen atoms in a vicinity of the NV-center, may be included in the system shown in FIG. 1. Including the nuclear spins in the model enables simulating interactions of the nuclear spins, such as the hyperfine interactions between the electronic spins and the nuclear spins. The spin Hamiltonian may further include terms relating to the nuclear Zeeman energies, nuclear spin-spin interactions, and the hyperfine interaction between electronic spins and nuclear spins.

FIGS. 3A and 3B show ionization dynamics for two different powers of the illumination laser 50. The illumination laser 50 illuminates a single NV-center (i.e., a single point defect) with the indicated laser power (1 mW or 3 mW) arranged in the semiconductor device 15 for an illumination duration of 5 $\mu$s. The laser power and the illumination duration are input parameters to the quantum mechanical model. Shown are the simulated electron current and the simulated hole current starting from different initialization states (the state $^3A_2$ with electronic spins $m_s = 0$, $m_s = -1$, as indicated in the insets) for a duration of 3 $\mu$s (the case for $m_s = 1$ is not shown in FIGS. 3A and 3B). The y-axis in FIGS. 3A and 3B indicate the electron current (left y-axis) and hole current (right y-axis) in MHz, i.e., in units of $10^6$ electrons/holes per second or, equivalently, 1 electron/hole per microsecond.

FIG. 3A, which has been simulated for the laser power being 1 mW, indicates that for the case $m_s = -1$, over the course of several microseconds, approximately one electron is photoelectrically generated by ionization (see above). FIG. 3B, which has been simulated for the laser power being 4 mW, indicates that for the case $m_s = -1$, over the course of approximately 1 microsecond. approximately one electron is photoelectrically generated by ionization. According to these results, the electrometer operating at an operation rate of at least 1 MHz enables the detection of a single charge carrier (i.e., of an electron or a hole).

In one aspect, the electrometer comprises at least one transistor. The at least one transistor may be a single-electron transistor (SET) or a bipolar transistor. An example of the bipolar transistor is a single-electron bipolar avalanche transistor.

In one aspect, an input charge noise for the SET is smaller than the sensitivity required at the operation rate (or equivalently, operation bandwidth). In one aspect, the SET has an input charge noise floor of approximately

$$10^{-4} \, e/\sqrt{\text{Hz}}$$, resulting in an ability to detect single electrons at - 1 MHz. When the input charge noise floor is <<

$$10^{-3} \, e/\sqrt{\text{Hz}}$$, single electrons may be measured at bandwidths > 1MHz.

As indicated by FIGS. 3A and 3B, the electron current and the hole current reach a substantially stationary value. Especially for the case of the laser power being 4 mW, the electron current and the hole current reach the substantially stationary value after approximately 2 $\mu$s. FIG. 3C shows the substantially stationary value reached by the photocurrent (indicated by "carriers" in the inset). FIG. 3C furthermore shows a substantially stationary value of a photon current (indicated by "photons" in the inset). The photon current is also shown in FIGS. 3D and 3E, which show the photoluminescence ("photodynamics") due the electromagnetic driving signal exciting the NV-center (i.e., the point defect) with the laser power being 1 mW or 4 mW. As can be seen from FIG. 3C by comparison, the photon current saturates at a laser power of approximately 2 mW and remains substantially constant for values of the laser power between approximately 2 mW and 6 mW.

FIG. 3F shows a contrast for the photocurrent and the photoluminescence. The contrast is calculated according to

$$Contrast = \frac{\int_0^T \left( p_{m_S=0}(t) - p_{m_S=\pm1}(t) \right) dt}{\int_0^T p_{m_S=0}(t) dt}$$

, with $T$ being the integration time (which is 1 $\mu$s for the simulation results shown) and $p$ being the sum of the generation rates of electrons and holes shown FIGS. 3A and 3B or the generation rate of photons shown in FIGS. 3D and 3E, for different initialization states of the electronic spin as indicated. The contrast differentiates efficiently between the electron spin states ($m_s = 0$, $m_s = -1$) where the value of the contrast is relatively large (the case for $m_s = 1$ is not shown in FIGS. 3A and 3B). For the photocurrent, the contrast peaks at the laser power being approximately 4 mW. For the photoluminescence, the contrast peaks at the laser power being approximately 2 mW.

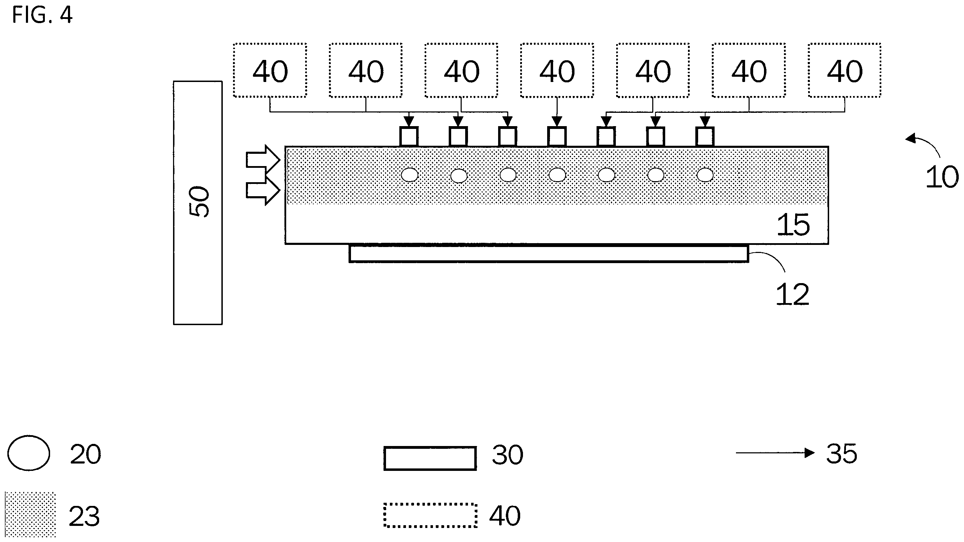

FIG. 4 shows the quantum information processing device according to the disclosure. The quantum information processing device 10 comprises a base 12, on which the semiconductor device 15 is arranged. The semiconductor device 15 comprises a semiconductor substrate 15 and a doped layer comprises dopants 23. The dopants 23 comprise electron acceptors and electron donors.

The doped layer further comprises the plurality of point defects 20 defects. The point defects may be arranged in the doped layer of the semiconductor device 15 during manufacturing. The point defects may be arranged in semiconductor device 15 having a predetermined one of the defect distance (see above with reference to FIG. 2).

The quantum information processing device 10 further comprises a plurality of electrodes 30 arranged on the surface (mentioned above with reference to FIG. 2). The plurality of electrodes 30 is electrically connected to a plurality of electrometers 40. A selected one of the plurality of electrodes 30 may be arranged in a vicinity of a selected one of the plurality of point defects 20. As shown in FIG. 4, the selected one of the plurality of point defects 20 may be associated with a unique one of the plurality of electrometers 40. Such arrangement enables the detection, by means of the unique one of the plurality of electrodes 30 associated with the selected one of the plurality of point defects 20 , of the transferred electron, transferred by ionization from the selected one of the plurality of point defects 20 to the conduction band of the semiconductor device 15.

In one aspect, the plurality of point defects 20 may comprise the NV-centers arranged in the semiconductor device 15 being made of diamond. In another aspect, the plurality of point defects 20 may comprise the silicon vacancy and/or the carbon vacancy arranged in the semiconductor device 15 being made of silicon carbide.

The quantum information processing device 10 further comprises an electromagnetic source or light emitting and delivery device 50. An example of the electromagnetic source 50 is the illumination laser 50 mentioned above.

The electromagnetic source 50 may be arranged on a chip 12. The semiconductor device 15 may be arranged on the chip 12 alongside the electromagnetic source 50.

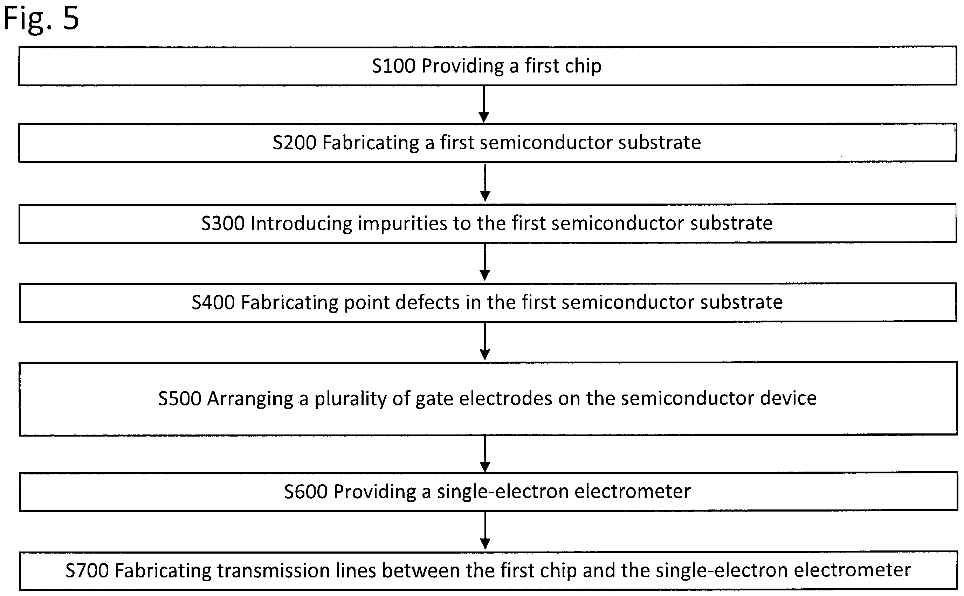

FIG. 5 shows a process for manufacturing the quantum information processing device 10. The manufacturing process comprises a first step S100, S20 of providing a semiconductor device 15. The first step S100, S20 of providing a semiconductor device 15 may comprise a step S100 of providing a chip 12. The first step S100, S20 of providing a semiconductor substrate 15 may further comprises a step S200 of fabricating the semiconductor substrate 15.

The method further comprises a step S400 of fabricating a plurality of point defects 20. The step S400 of fabricating a plurality of point defects 20 may comprise a step S300 of introducing impurities to the semiconductor substrate 15.

The method further comprises a step S500 of arranging a plurality of electrodes on the semiconductor substrate 15. The plurality of electrodes 30 may comprise gate electrodes. The plurality of electrodes 30 may further comprise control structures and readout structures on the semiconductor substrate 15.

The method further comprises a step S600 of providing a plurality of single-electron electrometers at the semiconductor substrate 15. The step S600 of providing the plurality of single-electron electrometers comprises a step S700 of electrically connecting the plurality of single-electron electrometers to the plurality of electrodes by means of transmission lines or electrical connections 35.

List of reference numerals

| Quantum information processing device | 10 |
|---|---|
| Semiconductor device / Semiconductor substrate | 15 |
| Base / chip | 12 |
| Point defects / NV-centers / Qubits | 20 |
| Dopants (Electron donors or acceptors) | 23 |
| Electrodes / Control structures / Readout structures | 30 |
| Transmission lines / Electrical connections | 35 |
| Electrometer / Single-electron electrometer | 40 |
| Electromagnetic source / Light emitting and delivery device | 50 |

**Claims**

1. A quantum information processing device (10) comprising a semiconductor device and a single-electron electrometer (40) electrically connected to the semiconductor device (15),

- the semiconductor device (15) comprising a plurality of point defects (20) having a plurality of quantum states associated with at least one electron;
- first transitions being effectible between first ones of the plurality of quantum states by means of electromagnetic signals interacting with the at least one electron;

- second transitions occurring between second ones of the plurality of states;;
wherein at least some of the plurality of point defects (20) are arranged in the semiconductor device (15) at distances below 20 nm, and
the single-electron electrometer (40) configured to be operated at frequencies of 1 MHz or more.

2. The quantum information processing device (10) of claim 1, wherein the single-electron electrometer (40) comprises an amplifier configured to be operated at frequencies of 1 MHz or more.

3. The quantum information processing device (10) of claim 2, wherein the amplifier comprises at least one of a single-electron transistor or a bipolar transistor.

4. The quantum information processing device (10) of any one of claims 1 to 3, further comprising an electromagnetic source (50) for generating the electromagnetic signals.

5. The quantum information processing device (10) of claim 4, wherein the electromagnetic source (50) is an optical source, and the electromagnetic signals are optical signals.

6. The quantum information processing device (10) of any one of claims 1 to 4, wherein the semiconductor device (15) further comprises impurities.

7. The quantum information processing device (10) of claim 5, wherein the impurities comprise electron donors and/or electron acceptors.

8. The quantum information processing device (10) of any one of claims 1 to 7, wherein the single-electron electrometer (40) is electrically connected to the semiconductor device (15) by means of electrodes (30).

9. A method of manufacturing a quantum information processing device (10), the method comprising the steps of

- providing (S100, S200) a semiconductor device (15);
- fabricating a plurality of point defects,

  - having a plurality of quantum states associated with at least one electron;
  - first transitions being effectible between first ones of the plurality of quantum states by means of electromagnetic signals interacting with the at least one electron;
  - second transitions occurring between second ones of the plurality of states; and
  - at least some of the plurality of point defects are arranged in the semiconductor device at distances below 20 nm;

- arranging a plurality of electrodes (30) on the semiconductor device (15);
- electrically connecting the semiconductor device (15) with a single-electron electrometer (40) via the plurality of electrodes (30),

wherein the single-electron electrometer (40) is configured to be operated at frequencies of 1MHz or more.

10. The method of claim 9, further comprising providing an electromagnetic source (50) for generating electromagnetic signals configured to interact with the plurality of point defects (20).

11. The method of claim 10 , wherein the providing of an electromagnetic source (50) comprises providing an optical source.

12. The method of any one of claims 9 to 11, further comprising introducing impurities to the semiconductor device.

13. The method of any one of claims 9 to 12, further comprising arranging the semiconductor device (15) on a chip (12).

14. The method of claim 11, further comprising arranging the electromagnetic source (50) on the chip (12).

**FIG. 1**

**FIG. 2**

- ● NV-centers
- ══ Interactions between NV-centers

FIG. 3A

Ionization Dynamics (1 mW)

FIG. 3B

Ionization Dynamics (4 mW)

FIG. 3C

FIG. 3D

Ionization Dynamics (1 mW)

FIG. 3E

Photodynamics (4 mW)

FIG. 3F

EP 4 579 757 A1

FIG. 4

## Fig. 5

| S100 Providing a first chip |
|---|

↓

| S200 Fabricating a first semiconductor substrate |
|---|

↓

| S300 Introducing impurities to the first semiconductor substrate |
|---|

↓

| S400 Fabricating point defects in the first semiconductor substrate |
|---|

↓

| S500 Arranging a plurality of gate electrodes on the semiconductor device |
|---|

↓

| S600 Providing a single-electron electrometer |
|---|

↓

| S700 Fabricating transmission lines between the first chip and the single-electron electrometer |
|---|

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2022/318661 A1 (MEIJER JAN BEREND [DE] ET AL) 6 October 2022 (2022-10-06) * paragraph [0035] * * paragraph [0081] - paragraph [0096] * * figures 1,2 * | 1-14 | INV. H01L29/16 H01L29/32 H01L29/76 |
| Y | EP 1 669 911 A2 (DWAVE SYS INC [CA]) 14 June 2006 (2006-06-14) * paragraph [0089] - paragraph [0094] * * figure 4 * | 1-14 | ADD. B82Y10/00 H01L29/40 |
| Y | ISHIHARA R ET AL: "3D Integration Technology for Quantum Computer based on Diamond Spin Qubits", 2021 IEEE INTERNATIONAL ELECTRON DEVICES MEETING (IEDM), IEEE, 11 December 2021 (2021-12-11), XP034096638, DOI: 10.1109/IEDM19574.2021.9720552 [retrieved on 2022-02-23] * Chapter "III. 3D Integration"; figure 2 * | 13,14 | |
| A | US 2023/026518 A1 (BURCHARD BERND [DE]) 26 January 2023 (2023-01-26) * abstract; figure 1 * | 1-14 | TECHNICAL FIELDS SEARCHED (IPC)  H01L G06N |

-/--

The present search report has been drawn up for all claims

| Place of search | Date of completion of the search | Examiner |
|---|---|---|
| Munich | 13 June 2024 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

**Application Number**

EP 23 38 6143

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SIYUSHEV PETR ET AL: "Photoelectrical imaging and coherent spin-state readout of single nitrogen-vacancy centers in diamond", SCIENCE, [Online] vol. 363, no. 6428, 15 February 2019 (2019-02-15), pages 728-731, XP055790464, US ISSN: 0036-8075, DOI: 10.1126/science.aav2789 Retrieved from the Internet: URL:https://science.sciencemag.org/content /sci/363/6428/728.full.pdf?casa_token=EtDc GrXX1f8AAAAA:qE_YkVngC1zEViJJbcXts-WoV_Ode a9958odMQrtLqSJAUe3I6rAfA1sROvyR7JW4q5TQrJ RIVABTzc> * the whole document * ----- | 1-14 | |
| | | | **TECHNICAL FIELDS SEARCHED (IPC)** |

The present search report has been drawn up for all claims

| Place of search | Date of completion of the search | Examiner |
|---|---|---|
| Munich | 13 June 2024 | Kostrzewa, Marek |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 38 6143

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2024

| Patent document cited in search report | Publication date | Patent family member(s) | Publication date |
|---|---|---|---|
| US 2022318661 A1 | 06-10-2022 | CN 114207631 A | 18-03-2022 |
| | | DE 102019120716 A1 | 04-02-2021 |
| | | EP 4004833 A1 | 01-06-2022 |
| | | US 2022318661 A1 | 06-10-2022 |
| | | WO 2021018654 A1 | 04-02-2021 |
| EP 1669911 A2 | 14-06-2006 | AT E332542 T1 | 15-07-2006 |
| | | AU 2002304920 A1 | 09-12-2002 |
| | | CA 2448682 A1 | 05-12-2002 |
| | | DE 60212967 T2 | 01-03-2007 |
| | | EP 1395947 A2 | 10-03-2004 |
| | | EP 1669911 A2 | 14-06-2006 |
| | | JP 2004533061 A | 28-10-2004 |
| | | US 2002188578 A1 | 12-12-2002 |
| | | US 2004167036 A1 | 26-08-2004 |
| | | US 2004170047 A1 | 02-09-2004 |
| | | WO 02097725 A2 | 05-12-2002 |
| US 2023026518 A1 | 26-01-2023 | AU 2020376131 A1 | 12-05-2022 |
| | | CN 115280331 A | 01-11-2022 |
| | | DE 102020007977 A1 | 29-04-2021 |
| | | DE 102020008157 B3 | 17-11-2022 |
| | | DE 102020125169 A1 | 29-04-2021 |
| | | DE 102020125171 A1 | 29-04-2021 |
| | | DE 102020125172 A1 | 29-04-2021 |
| | | DE 102020125173 A1 | 29-04-2021 |
| | | DE 102020125174 A1 | 29-04-2021 |
| | | DE 102020125175 A1 | 29-04-2021 |
| | | DE 102020125176 A1 | 29-04-2021 |
| | | DE 102020125177 A1 | 29-04-2021 |
| | | DE 102020125178 A1 | 29-04-2021 |
| | | DE 102020125179 A1 | 29-04-2021 |
| | | DE 102020125180 A1 | 29-04-2021 |
| | | DE 102020125181 A1 | 29-04-2021 |
| | | DE 102020125182 A1 | 29-04-2021 |
| | | DE 102020125183 A1 | 29-04-2021 |
| | | DE 102020125185 A1 | 29-04-2021 |
| | | DE 102020125186 A1 | 29-04-2021 |
| | | DE 102020125187 A1 | 29-04-2021 |
| | | DE 102020125188 A1 | 29-04-2021 |
| | | DE 102020125189 A1 | 12-05-2021 |
| | | DE 102020125190 A1 | 29-04-2021 |
| | | DE 102020125191 A1 | 29-04-2021 |
| | | DE 112020004589 A5 | 02-06-2022 |
| | | DE 202020005427 U1 | 14-05-2021 |
| | | DE 202020005770 U1 | 18-05-2022 |

EPO FORM P0459

For more details about this annex : see Official Journal of the European Patent Office, No. 12/82

page 1 of 2

**ANNEX TO THE EUROPEAN SEARCH REPORT**
**ON EUROPEAN PATENT APPLICATION NO.**

EP 23 38 6143

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2024

| Patent document cited in search report | Publication date | Patent family member(s) | Publication date |
|---|---|---|---|
| | | DE 202020005921 U1 | 24-07-2023 |
| | | DE 202020005922 U1 | 02-05-2023 |
| | | DE 202020005933 U1 | 30-06-2023 |
| | | DE 202020005957 U1 | 25-09-2023 |
| | | EP 4042337 A1 | 17-08-2022 |
| | | IL 292228 A | 01-06-2022 |
| | | US 2023026518 A1 | 26-01-2023 |
| | | WO 2021083448 A1 | 06-05-2021 |

EPO FORM P0459

For more details about this annex : see Official Journal of the European Patent Office, No. 12/82

page 2 of 2